# FASCICULE DE BREVET EUROPEEN

(11) **EP 4 174 585 B1**
(45) Date de publication et mention de la délivrance du brevet: **13.08.2025**
(21) Numéro de dépôt: 21205701.2
(22) Date de dépôt: 29.10.2021
(51) Int. Cl.: G04B 19/04, G04B 19/12, G04B 19/32

(54) **PROCÉDÉ DE FABRICATION D'UN COMPOSANT HORLOGER LUMINESCENT**
VERFAHREN ZUR HERSTELLUNG EINER LEUCHTENDEN UHRENKOMPONENTE
METHOD FOR MANUFACTURING A LUMINESCENT CLOCK COMPONENT

(43) Date de publication de la demande: 03.05.2023
(73) Titulaire: The Swatch Group Research and Development Ltd, 2074 Marin (CH)
(72) Inventeur: NAPOLI, Sophie, 2000 Neuchâtel (CH); FRANÇOIS, Nicolas, 2000 Neuchâtel (CH)
(74) Mandataire: ICB SA

(56) Documents cités:
- WO-A1-97/33208
- US-A1- 2018 095 427
- US-A1- 2020 201 260

## Description

### Domaine technique de l'invention

L'invention est relative à un procédé de fabrication d'un composant horloger luminescent. La présente invention concerne également un tel composant horloger obtenu à partir du procédé de fabrication.

### Arrière-plan technologique

L'utilisation de matériaux photoluminescents est assez répandue sur le marché et ce pour des applications variées, telles que les aiguilles ou les index.

La technologie de phosphorescence est couramment utilisée dans le domaine de l'horlogerie via différentes méthodes de décoration afin d'illuminer aiguilles, cadrans et autres composants.

La technologie de fluorescence est également utilisée pour la décoration des composants d'habillage interne via la tampographie ou le sprayage utilisant les pigments fluorescents afin de décorer la montre et ce en plusieurs couleurs.

D'autre part, les cadrans et les aiguilles sont habituellement réalisés dans une matière métallique puis, après plusieurs étapes de terminaisons, décorés avec une encre soit phosphorescente, soit fluorescente. Le document US 2020/201260 A1 divulgue la production d'un composant horloger luminescent par extrusion d'un mélange composé d'un pigment phosphorescent et d'une résine thermoplastique.

Cette conception présente plusieurs inconvénients:
- la limitation des performances lumineuse, les épaisseurs des encres phosphorescentes et fluorescentes sont limitées à une centaine de microns avec les procédés de décoration actuels ;
- une complexification des procédés de décoration, une sous couche blanche est parfois nécessaire avant la décoration phosphorescente afin d'avoir un décor opaque et de maximiser les performances ;
- les composants complètement opaques limitant le design.

### Résumé de l'invention

L'invention vise à fournir un procédé de fabrication d'un composant horloger luminescent qui ne souffre pas des inconvénients décrits ci-dessus.

La présente invention concerne un procédé de fabrication d'un composant horloger luminescent pour un objet portable comprenant les étapes suivantes :
- réaliser un pré-mélange d'un pigment phosphorescent à hauteur de 10 à 40% massique, un pigment fluorescent à hauteur de 1 à 4% massique et un plastifiant à une hauteur maximale de 10% massique ;
- mélanger une base polymère audit pré-mélange et extruder un première fois le mélange obtenu pour obtenir un mélange polymère homogène ;
- extruder une seconde fois le mélange polymère sur une machine d'extrusion mono-vis munie d'une filière permettant la réalisation de bandes calandrées d'une épaisseur d'au moins 0.3mm ;
- découper la bande pour obtenir le composant horloger luminescent souhaité ;

Conformément à d'autres variantes avantageuses de l'invention :
- la base polymère est une base de polymère thermoplastique ;
- la base polymère est transparente aux longueurs d'onde du spectre proche des ultra-violets et aux longueurs d'onde du spectre visible ;
- la base polymère thermoplastique est choisie parmi le polycarbonate, le PMMA, ....
- la bande extrudée est refroidie à température ambiante ;
- la première extrusion est effectuée via une extrudeuse bi-vis ;
- la seconde extrusion est effectuée via une extrudeuse mono-vis ;
- la bande obtenue lors de la seconde extrusion se présente sous la forme d'une bande en deux parties, une première partie dite supérieure est formée par le mélange luminescent obtenu à la fin de de la première extrusion, et la deuxième partie dite partie inférieure est formée par une bande en matière polymère blanche.

### Description détaillée de l'invention

La présente invention concerne un procédé de fabrication d'un composant horloger luminescent pour un objet portable.

Par luminescent, on entend que le composant est photoluminescent, fluorescent, phosphorescente, ou une combinaison.

Par phosphorescent, on entend un élément ayant la propriété de pouvoir absorber de la lumière et de la réémettre à une longueur d'onde plus grande. L'émission persiste un certain temps quand l'excitation lumineuse a cessé. L'encre contient au moins un agent photoluminescent pour conférer les propriétés de photoluminescence à l'encre. Préférentiellement, l'agent luminescent est un agent fluorescent. Il est, avantageusement, choisi parmi les fluorophores inorganiques et les complexes organo-lanthanides. Selon une autre alternative, l'agent fluorescent peut également être choisi parmi les fluorophores organiques. Il peut s'agir, par exemple, de fluorescéine, d'europium 1 ,3-diphenyl-1 ,3- propanedionate-1 ,10-phenantroline, d'oxysulfure de gadolinium dopé, d'aluminate de baryum et magnésium dopé, d'aluminate de lithium dopé, de molybdate de strontium dopé.

Par fluorescent, on entend un élément ayant la propriété de pouvoir absorber de la lumière et de la réémettre à une longueur d'onde plus grande. L'émission cesse quand l'excitation lumineuse cesse.

Les diverses étapes du procédé de fabrication selon l'invention vont maintenant être décrite.

Au cours d'une première étape, on effectue un pré-mélange d'un pigment phosphorescent à hauteur de 10 à 40% massique, d'un plastifiant et un pigment fluorescent à hauteur de 4% massique de manière à obtenir une couleur de jour suffisamment voyante sans faire de compromis sur les performances phosphorescentes. La quantité de particules luminescentes est choisie de manière à être suffisante pour pouvoir démarquer le composant horloger décoré et le rendre facilement et immédiatement visible dans l'obscurité. Les plastifiant sont présents à une hauteur maximale de 10% massique pour ajuster la malléabilité de la base polymère par la suite et ainsi la rendre moins cassante lors des manipulations et de l'usinage. Ce pré-mélangeage permet d'enrober les pigments, d'éviter leur abrasion et de faciliter leur incorporation dans la base polymère pour la suite du procédé. Les polyéthylènes, les paraffines, ou encore les polydimethoxysilanes sont couramment utilisés en tant que plastifiant.

Le pigment fluorescent diurne est ajouté à hauteur de 1 à 4% massique, ce qui permet de modifier la couleur visible de jour car ces pigments fluorescents sont colorés. Les pigments fluorescents diurne sont l'équivalent de « Daylight fluorescent pigment », ces pigments possèdent une couleur de jour contrairement au « UV Light fluorescent pigment » qui sont de couleur neutre sous la lumière du jour mais excités par la lumière UV. Ils permettent aussi de renforcer et de modifier l'effet phosphorescent via une conversion énergétique. Par exemple si on utilise un pigment phosphorescent émission bleue « Light Blue », et qu'on ajoute du pigment fluorescent rose, alors la couleur finale d'émission de nuit sera rosée/violette. Il est donc possible, selon les mélanges effectués, de faire correspondre la couleur fluorescente visible de jour avec la couleur phosphorescente visible de nuit.

Au cours de l'étape suivante, on effectue un mélange avec le pré-mélange et une base polymère, puis une première extrusion du pré-mélange pour obtenir un mélange homogène et bien répartir les particules luminescentes dans la base polymère et ainsi éviter des amas de particules qui nuiraient à la fois au rendu visuel sur le composant horloger et aux performances des pigments luminescents. Le polymère de base est ainsi mélangé avec le pré-mélange à base de plastifiant et de pigments afin de pouvoir permettre un glissement entre les chaines.

La base polymère utilisée peut être un polymère thermoplastique tel que le polycarbonate (PC), le polyamide (PA) le Methylmethacrylate Acrylonitrile Butadiene Styrene (MABS), le polyéthylène téréphtalate glycolisé (PETg), etc. Avantageusement, la base polymère utilisée est à la fois transparentes aux longueurs d'onde du spectre proche des ultra-violets et aux longueurs d'onde du spectre visible, cela permet une meilleure absorption de la lumière par les pigments.

De préférence, l'extrusion est réalisée via une extrudeuse bi-vis de manière à obtenir un mélange homogène et une bonne dispersion des pigments. A l'issue de cette première extrusion, la matière sort généralement sous forme de granulés, ce qui permet de faciliter le transport et le stockage pour la suite du procédé.

La matière obtenue lors de la première extrusion est ensuite ré-extrudé sur une machine d'extrusion mono-vis munie d'une filière permettant la réalisation de bandes calandrées d'une épaisseur d'au moins 0.3mm. L'épaisseur peut bien évidemment être amenée à varier en fonction du composant horloger que l'on souhaite obtenir à la fin. Il a été constaté par les inventeurs qu'en dessous une épaisseur de 0.3 mm, les pièces sont trop fragiles et ne se tiennent pas mécaniquement Par exemple, une aiguille de 0.15 mm est trop souple et présente des performances mécaniques inhomogènes, l'aiguille ne supportant pas son propre poids. Ainsi, afin de garantir de bonnes performances et une bonne tenue, une épaisseur minimum de 0.3 mm est souhaitée.

Selon une variante de l'invention, le profilé obtenu lors de la deuxième extrusion se présente sous la forme d'une bande en deux parties, une première partie dite supérieure est formée par le mélange obtenu à la fin de de la première extrusion, et la deuxième partie dite partie inférieure est formée par une bande en matière polymère blanche. Une telle disposition permet d'obtenir une couche réfléchissante sous la couche en matière luminescente et ainsi d'obtenir de meilleures performances.

Il n'y a pas de limitation supérieure d'épaisseur. Il est possible de faire directement l'épaisseur de la pièce et de découper la pièce si cette dernière est plane. Il est également possible d'extruder des bandes plus épaisses et d'usiner les pièces après découpe pour aussi les reprendre en épaisseur. Par exemple, pour des aiguilles afin de pouvoir découper le dessus de l'aiguille plus large et un pied plus fin. Pour des raisons de coût, la filière peut être adaptée à la section de l'aiguille la plus grande afin d'extruder le profil de celle-ci.

Une fois le compound ré-extrudé, la bande est découpée, via un étampage ou une découpe laser par exemple, pour obtenir le composant horloger luminescent souhaité.

Finalement, une dernière étape optionnelle consiste à décorer par impression ou gravage le composant horloger obtenu de manière à ce que seulement une partie luminescente du composant soit visible.

Selon l'invention, un tel procédé permet d'obtenir un cadran ou des aiguilles luminescente.

### Exemple de réalisation

Un pré-mélange est effectué en mélangeant un agent plastifiant à une hauteur maximale de 10% massique avec un pigment photoluminescent à hauteur de 10 à 40% massique (particule size D50 : 15-20 µm) et un pigment fluorescent est ensuite ajouté à hauteur de 1 à 4% massique. L'agent plastifiant permet d'améliorer la solidité de la matière, et optimiser les interactions matrice-pigment phosphorescent.

Une base polymère est ensuite mélangée au pré-mélange.

Le mélange est homogénéisé via une première extrusion bi-vis.

Une seconde extrusion du compound est ensuite effectuée pour former une bande d'une épaisseur d'au moins 0.3 mm.

Refroidissement de la bande à température ambiante.

Une fois que la bande est formée et refroidie, celle-ci est découpée via laser ou étampage afin d'obtenir les pièces horlogères souhaitées.

## Revendications

1. Procédé de fabrication d'un composant horloger luminescent pour un objet portable, ledit procédé étant **caractérisé en ce qu'**il comprend les étapes suivantes :
- réaliser un pré-mélange d'un pigment phosphorescent à hauteur de 10 à 40% massique, un pigment fluorescent à hauteur de 1 à 4% massique et un plastifiant à une hauteur maximale de 10% massique ;
- mélanger une base polymère audit pré-mélange et extruder un première fois le mélange obtenu pour obtenir un mélange polymère homogène ;
- extruder une seconde fois le mélange sur une machine d'extrusion mono-vis munie d'une filière permettant la réalisation de bandes calandrées d'une épaisseur d'au moins 0.3mm ;
- découper la bande pour obtenir le composant horloger luminescent souhaité.

2. Procédé de fabrication selon la revendication 1, **caractérisé en ce que** la base polymère est une base de polymère thermoplastique.

3. Procédé de fabrication selon la revendication 1 ou 2, caractérisé en ce la base polymère est transparente aux longueurs d'onde du spectre proche des ultra-violets et aux longueurs d'onde du spectre visible.

4. Procédé de fabrication selon les revendications 1 à 3, dans lequel la base polymère thermoplastique est choisie parmi le polycarbonate, le PMMA.

5. Procédé de fabrication selon les revendications 1 à 4, dans lequel la bande extrudée est refroidie à température ambiante.

6. Procédé de fabrication selon les revendications 1 à 5, dans lequel la première extrusion est effectuée via une extrudeuse bi-vis.

7. Procédé de fabrication selon les revendications 1 à 6, dans lequel la bande obtenue lors de la seconde extrusion se présente sous la forme d'une bande en deux parties, une première partie dite supérieure est formée par le mélange luminescent obtenu à la fin de de la première extrusion, et la deuxième partie dite partie inférieure est formée par une bande en matière polymère blanche.

8. Procédé de fabrication selon les revendications 1 à 7 dans lequel le composant horloger luminescent formé est un cadran ou une aiguille.

## Patentansprüche

1. Verfahren zur Herstellung einer lumineszierenden Uhrwerkskomponente für ein tragbares Objekt, wobei dieses Verfahren durch die folgenden Schritte gekennzeichnet ist:
- Anfertigen einer Vormischung aus 10 bis 40 Gew.-% phosphoreszierendem Pigment, 1 bis 4 Gew.-% fluoreszierendem Pigment und maximal 10 Gew.-% Weichmacher;
- Zumischen einer Polymerbasis zu dieser Vormischung und einmaliges Extrudieren der erhaltenen Mischung zur Erzeugung einer homogenen Polymermischung;
- Zweifaches Extrudieren der Mischung auf einer Einschnecken-Extrusionsmaschine mit einer Düse, die die Herstellung kalandrierter Bänder mit einer Dicke von mindestens 0,3 mm ermöglicht;
- Zuschneiden des Bandes zur Gewinnung der gewünschten lumineszierenden Uhrwerkskomponente.

2. Verfahren nach Anspruch 1, **dadurch gekennzeichnet, dass** die Polymerbasis eine thermoplastische Polymerbasis ist.

3. Verfahren nach Anspruch 1 oder 2, **dadurch gekennzeichnet, dass** die Polymerbasis im nahen ultravioletten sowie im sichtbaren Spektralbereich transparent ist.

4. Verfahren nach den Ansprüchen 1 bis 3, wobei die thermoplastische Polymerbasis aus Polycarbonat oder PMMA besteht.

5. Verfahren nach den Ansprüchen 1 bis 4, wobei das extrudierte Band auf Raumtemperatur abgekühlt wird.

6. Verfahren nach den Ansprüchen 1 bis 5, wobei die erste Extrusion mittels eines Doppelschneckenextruders erfolgt.

7. Verfahren nach den Ansprüchen 1 bis 6, wobei das beim zweiten Extrusionsvorgang erhaltene Band zweiteilig ausgebildet ist, wobei der sogenannte obere Teil aus der am Ende der ersten Extrusion gewonnenen lumineszierenden Mischung besteht und der sogenannte untere Teil aus einem Streifen weißen Polymermaterials besteht.

8. Verfahren nach den Ansprüchen 1 bis 7, wobei die gebildete lumineszierende Uhrwerkskomponente ein Zifferblatt oder ein Zeiger ist.

## Claims

1. Method for manufacturing a luminescent timepiece component for a portable object, said method being **characterised in that** it comprises the steps of:
- producing a pre-mixture of a phosphorescent pigment in an amount of 10 to 40% by weight, a fluorescent pigment in an amount of 1 to 4% by weight and a plasticiser in a maximum amount of 10% by weight;
- mixing a polymer base with said pre-mixture and extruding a first time the mixture obtained to obtain a homogeneous polymer mixture;
- extruding a second time the mixture on a single-screw extruder equipped with a die for producing calendered strips of a thickness of at least 0.3 mm;
- cutting the strip to obtain the desired luminescent timepiece component.

2. Manufacturing method according to claim 1, **characterised in that** the polymer base is a thermoplastic polymer base.

3. Manufacturing method according to claim 1 or 2, **characterised in that** the polymer base is transparent at wavelengths of the near ultra-violet spectrum and at wavelengths of the visible spectrum.

4. Manufacturing method according to claim 1 to 3, wherein the thermoplastic polymer base is selected from polycarbonate, PMMA.

5. Manufacturing method according to claims 1 to 4, wherein the extruded strip is cooled at ambient temperature.

6. Manufacturing method according to claims 1 to 5, wherein the first extrusion is performed via a twin-screw extruder.

7. Manufacturing method according to claims 1 to 6, wherein the strip obtained during the second extrusion is in the form of a strip in two portions, a first portion referred to as upper is formed by the luminescent mixture obtained at the end of the first extrusion, and the second portion referred to as lower portion is formed by a strip made of white polymer material.

8. Manufacturing method according to claims 1 to 7, wherein the luminescent timepiece component formed is a dial or a hand.
